# DEMANDE DE BREVET EUROPEEN

(11) **EP 3 435 418 A1**
(43) Date de publication de la demande: **30.01.2019**
(21) Numéro de dépôt: 18185324.3
(22) Date de dépôt: 24.07.2018
(51) Int. Cl.: H01L 27/30, H01L 51/44

(54) **CELLULE PHOTOVOLTAÏQUE EWT DE TYPE ORGANIQUE OU PÉROVSKITE ET SON PROCÉDÉ DE RÉALISATION**

(30) Priorité: 25.07.2017 FR 1757057
(71) Demandeur: Commissariat à l'énergie atomique et aux énergies alternatives, 75015 Paris (FR)
(72) Inventeur: MATHERON, Muriel, 73000 CHAMBERY (FR); BERSON, Solenn, 73000 CHAMBERY (FR); CROS, Stéphane, 73000 CHAMBERY (FR)
(74) Mandataire: Brevalex

(57) **Abrégé**

Cellule photovoltaïque organique ou pérovskite comprenant un substrat (100) comprenant :
- une première électrode (106),
- une couche électriquement isolante (108),
- une seconde électrode (110),
- une couche en matériau d'un premier type de conductivité (112), et
- une couche active (114),
le substrat (100) comprenant une pluralité de trous borgnes (200), la première électrode (106) définissant le fond des trous borgnes (200),
le substrat (100) étant recouvert par une couche en matériau d'un second type de conductivité (116), opposé au premier type de conductivité, la couche en matériau d'un second type de conductivité (116) remplissant au moins partiellement les trous borgnes (200) de manière à prendre contact avec la première électrode (106).

La cellule photovoltaïque comporte, en outre, une couche d'isolation électriquement isolante (300) tapissant la paroi latérale des trous borgnes.

## Description

### DOMAINE TECHNIQUE ET ÉTAT DE LA TECHNIQUE ANTÉRIEURE

L'invention concerne le domaine des cellules photovoltaïques de type organique ou pérovskite, et plus particulièrement celui des cellules photovoltaïques à contacts en face arrière, de type EWT.

L'invention concerne également un procédé de réalisation de telles cellules photovoltaïques.

Classiquement, les cellules photovoltaïques de type organique ou pérovskite comportent une couche active, qui a pour fonction d'absorber les photons et de générer les charges libres. Cette couche active est disposée entre deux couches d'interface de conductivité opposée, l'une de type N et l'autre de type P, qui sélectionnent les charges générées (les électrons pour la couche de type N et les trous pour la couche de type P), et les transportent vers les électrodes disposées de part et d'autre des couches de type N et P.

L'électrode disposée sur la face avant de la cellule photovoltaïque doit être électriquement conductrice et optiquement transparente, de manière à laisser passer les photons jusqu'à la couche active. Cette électrode peut être en oxyde transparent conducteur, typiquement de l'oxyde d'indium-étain (ITO) ou de l'oxyde de zinc dopé à l'aluminium (ZnO:Al), ou encore elle peut être formée d'un polymère transparent conducteur comprenant des nanofils d'argent par exemple.

Cependant, ces électrodes transparentes sont relativement chères et nécessitent l'utilisation d'éléments rares tels que l'indium. De plus, comme l'ITO est faiblement conducteur, son utilisation limite la taille des cellules. L'obtention de cellules grandes surfaces impose d'ajouter une grille métallique à sa surface, ce qui augmente l'ombrage de la cellule photovoltaïque, et diminue son rendement surfacique (puissance/m²).

Pour éviter d'utiliser des électrodes transparentes, il est possible de réaliser des cellules photovoltaïques de type EWT (pour « Emitter Wrap Through »). Les articles de Schiefer et al (Solar Energy Materials & Solar Cells 115 (2013 29-35) et de Zimmermann et al. (Solar Energy Materials & Solar Cells 91 (2007) 374-378) représentent une telle architecture. Les électrodes sont disposées en face arrière de la cellule. Des électrodes métalliques peuvent ainsi être utilisées, ce qui réduit les coûts de fabrication et augmente les possibilités de choix en terme de nature et de géométrie d'électrodes. Seule la couche supérieure d'interface doit être transparente, et présenter un minimum de conductivité pour collecter les charges en latéral.

L'interconnexion entre la couche d'interface supérieure et l'électrode en face arrière du substrat est réalisée grâce à la réalisation de trous ou vias, traversant le substrat. Les trous sont généralement réalisés par ablation laser et présentent un diamètre pouvant être de l'ordre de 20-100 µm. La couche supérieure d'interface est ensuite formée en déposant une couche de type N ou P sur la face avant de la cellule et dans les trous.

Les cellules photovoltaïques sont, classiquement, protégées des éléments extérieurs, en particulier de l'air (vapeur d'eau et dioxygène), par des couches d'encapsulation. La mise en oeuvre de l'encapsulation est réalisée en positionnant les cellules entre deux couches de matériaux dits « barrières aux gaz ». Les matériaux barrières aux gaz sont classiquement des couches denses (par exemple des plaques de verre ou de métal) ou des films multicouches associant de fines couches inorganiques denses placées entre des couches organiques. Le film barrière ou la couche d'isolation rigide (verre ou métal) peut être maintenu sur la cellule photovoltaïque grâce à un adhésif sensible à la pression, à une colle liquide ou à un polymère thermoplastique mis en oeuvre par laminage sous vide par exemple. Un exemple de polymère thermoplastique est un film en copolymère éthylène/acétate de vinyle EVA. Ce film encapsulant a une épaisseur comprise, typiquement, entre 50 µm et 500 µm.

Cependant, dans le cas des cellules EWT, de l'air et de l'humidité peuvent être parfois piégés dans les trous du substrat, au moment de l'encapsulation.

L'air piégé peut réagir et modifier les propriétés physico-chimiques des couches actives, des couches d'interfaces ou des électrodes, notamment dans le cas des cellules organiques de type polymère ou pérovskites, ce qui réduit la durée de vie des cellules.

### EXPOSÉ DE L'INVENTION

C'est par conséquent un but de la présente invention de proposer une cellule photovoltaïque organique ou pérovskite de type EWT présentant une meilleure protection vis-à-vis de l'air et de l'humidité.

Pour cela, la présente invention propose une cellule photovoltaïque organique ou pérovskite comprenant un substrat muni d'une première face principale et d'une seconde face principale parallèles entre elles, dans laquelle :
le substrat comprend depuis la première face principale vers la seconde face principale un empilement formé de :
   - une première électrode,
   - une couche électriquement isolante,
   - une seconde électrode,
   - une couche en matériau d'un premier type de conductivité, et
   - une couche active,
le substrat comprend une pluralité de trous borgnes, chaque trou borgne étant formé d'une ouverture, d'un fond et d'une paroi latérale, l'ouverture étant disposée au niveau de la seconde face, la première électrode définissant le fond des trous borgnes, et
la cellule photovoltaïque comporte, en outre, une couche d'isolation électriquement isolante tapissant la paroi latérale des trous borgnes.

La couche d'isolation a un rôle de couche barrière. Par couche barrière, on entend que la couche d'isolation a, par exemple, une perméabilité à l'eau inférieure à 10⁻¹g.m⁻².s¹, à 38°C pour 85% d'humidité relative. Ainsi par rapport aux architectures existantes, la cellule photovoltaïque est au moins partiellement protégée de l'air et de l'humidité par la couche d'isolation. L'air piégé durant l'étape d'encapsulation aura peu d'impact sur la durée de vie et les performances de la cellule photovoltaïque. L'étape d'encapsulation de la cellule photovoltaïque est ainsi moins critique et les matériaux utilisés pour l'encapsulation peuvent être moins performants, et moins coûteux, que si la cellule photovoltaïque était dépourvue de cette couche isolante. L'homme du métier pourra employer une technique d'encapsulation classiquement utilisée dans le domaine solaire.

La couche d'isolation est choisie de manière à isoler électriquement une couche en matériau d'un second type de conductivité, qui est formée sur le substrat et qui se prolonge dans les trous borgnes, de la seconde électrode, et de la couche en matériau d'un premier type de conductivité. La couche d'isolation présente, par exemple, une mobilité µ inférieure à 1 cm²/V.s.

Avantageusement, la couche d'isolation a une épaisseur conforme. Par conforme, on entend que l'épaisseur de la couche est constante sur la totalité de la couche quelles que soient les irrégularités et le facteur de forme de la surface sous-jacente. Il est possible d'atteindre des facteurs de forme de 1/100. Par exemple, pour une couche de 5 nm, en tout point de la couche, l'épaisseur aura une variabilité inférieure à 10% à 1 sigma.

Selon une première variante, la couche d'isolation est en alumine ou en silice et elle a une épaisseur strictement supérieure ou égale à 5 nm, de préférence allant de 5 nm à 25 nm. Avantageusement, la couche d'isolation évite les phénomènes de fuite au niveau de l'interface entre les couches de conductivités opposées ou entre la couche active et la seconde électrode.

Alternativement, la couche d'isolation peut être constituée de toute couche dense inorganique (oxydes métalliques type AlOₓ, SiOₓ, TiOₓ, ZnSnOₓ, niture de silicium SiNₓ, oxyniture de silicium SiOₓN_{y}) avec une composition homogène ou à gradient de composition.

Selon une autre variante, la couche d'isolation peut être en alumine ou en silice et elle peut avoir une épaisseur strictement inférieure à 5 nm, de préférence comprise entre 1 nm et 5 nm, de manière à permettre la conduction des charges par effet tunnel. La couche d'isolation peut ainsi recouvrir le fond du trou et la seconde face du substrat, ce qui facilite sa réalisation.

Conformément à l'invention, le substrat est avantageusement recouvert par une couche en matériau d'un second type de conductivité, opposé au premier type de conductivité, laquelle couche en matériau d'un second type de conductivité remplit au moins partiellement les trous borgnes. Cette couche peut être une couche différente de la couche d'isolation ou faire partie de la couche d'isolation.

Ainsi, selon un premier mode de réalisation, la couche en matériau d'un second type de conductivité est une couche différente de la couche d'isolation et la couche en matériau d'un second type de conductivité remplit au moins partiellement les trous borgnes de manière à prendre contact avec la première électrode. Par « prendre contact avec la première électrode », on entend qu'un transfert de charges est possible entre la couche d'un second type de conductivité et la première électrode.

En variante, la couche d'isolation, outre de tapisser la paroi des trous borgnes, recouvre le fond de ces trous et la couche en matériau d'un second type de conductivité - qui est également une couche différente de la couche d'isolation - remplit au moins partiellement les trous borgnes de manière à être au contact de la partie de la couche d'isolation qui recouvre le fond de ces trous.

Selon un autre mode de réalisation, la couche en un matériau de second type de conductivité fait partie de la couche d'isolation, auquel cas la couche d'isolation est en contact avec la première électrode et elle présente un gradient de conductivité électrique, dans un plan perpendiculaire à l'épaisseur de la couche d'isolation, la surface interne de la couche d'isolation en contact avec la paroi latérale du trou borgne étant en un matériau électriquement isolant et la surface externe, opposée à la surface interne, étant en un matériau d'un second type de conductivité, opposé au premier type de conductivité. Par gradient de conductivité électrique, on entend que la conductivité électrique évolue graduellement sur toute l'épaisseur de la couche d'isolation. Ainsi, la même couche (« monocouche ») présente des propriétés d'isolation et des propriétés de conductivité (type N ou P).

La couche d'isolation peut, selon une variante, être sous la forme d'un bicouche comprenant une couche électriquement isolante et une couche d'un second type de conductivité. Une couche possédant des propriétés barrières peut également recouvrir la couche d'isolation pour renforcer la protection vis-à-vis de l'air et de l'humidité.

Selon une variante, la couche d'un second type de conductivité peut présenter des propriétés de protection vis-à-vis de l'air et de l'humidité.

Avantageusement, la couche d'isolation peut présenter un gradient de densité et/ou un gradient de dopant, dans un plan perpendiculaire à l'épaisseur de la couche d'isolation, i.e. depuis la paroi latérale du trou borgne vers le centre du trou borgne.

Le matériau d'un second type de conductivité peut être du TiO₂, du WO₃ dopé ou non dopé, ZnO ou du ZnO:Al.

Avantageusement, la couche d'isolation recouvre la couche active afin de mieux protéger le substrat de l'air (dioxygène et humidité).

Conformément à l'invention, la cellule photovoltaïque peut être une cellule « tandem », auquel cas l'empilement que comprend le substrat depuis la première face principale vers la seconde face principale est avantageusement formé de :
- la première électrode,
- la couche électriquement isolante,
- la seconde électrode,
- une première couche en matériau d'un premier type de conductivité, par exemple de type N,
- une première couche active,
- une couche en matériau d'un deuxième type de conductivité, opposé au premier type de conductivité, par exemple de type P,
- une deuxième couche en matériau d'un premier type de conductivité, par exemple de type N, et
- une deuxième couche active.

Auquel cas également, la couche d'isolation recouvre avantageusement la deuxième couche active.

L'invention concerne, en outre, un procédé de réalisation d'une cellule photovoltaïque organique ou pérovskite, comportant au moins les étapes de :
a) réalisation d'un substrat comportant une première face principale et une seconde face principale parallèles l'une par rapport à l'autre,
   le substrat comprenant depuis la première face principale vers la seconde face principale un empilement comprenant :
   - une première électrode,
   - une couche électriquement isolante,
   - une seconde électrode,
   - une couche en matériau d'un premier type de conductivité, et
   - une couche active,
b) réalisation d'une pluralité de trous borgnes, chaque trou borgne étant formé d'une ouverture, d'un fond et d'une paroi latérale, l'ouverture étant disposée au niveau de la seconde face, la première électrode définissant le fond du trou borgne,
c) dépôt d'une couche d'isolation électriquement isolante sur la paroi latérale et sur le fond des trous borgnes.

Avantageusement, la couche d'isolation électriquement isolante est formée par dépôt de couche atomique. Ce type de dépôt permet d'obtenir des couches combinant à la fois les propriétés de conformité et, en même temps, les propriétés barrières et d'isolation électrique, voire même la perméabilité et/ou la densité, recherchées.

Avantageusement, le procédé comporte une étape d) ultérieure dans laquelle une couche en matériau d'un second type de conductivité, opposé au premier type de conductivité, est déposée sur le substrat, la couche en matériau d'un second type de conductivité remplissant au moins partiellement les trous borgnes de manière à prendre contact avec la seconde électrode.

Entre l'étape c) et l'étape d), le procédé peut comprendre une étape additionnelle dans laquelle la partie de la couche d'isolation recouvrant le fond du trou est gravée, de manière à rendre accessible la première électrode.

Avantageusement, la couche d'isolation présente un gradient de conductivité électrique, dans un plan perpendiculaire à l'épaisseur de la couche d'isolation, la surface interne de la couche d'isolation en contact avec la paroi latérale du trou borgne étant en un matériau électriquement isolant et la surface externe, opposée à la surface interne, étant en un matériau d'un second type de conductivité, opposé au premier type de conductivité. Un tel procédé permet de réaliser en une seule étape une monocouche présentant, à la fois, des propriétés de protection et les propriétés d'un matériau d'un second type de conductivité, tout en étant isolé électriquement de la couche en matériau d'un premier type de conductivité et de l'électrode associée.

De manière avantageuse, le procédé comporte une étape ultérieure dans laquelle la cellule photovoltaïque est encapsulée.

Lorsque la cellule photovoltaïque est de type tandem, alors le substrat réalisé à l'étape a) comprend avantageusement depuis sa première face principale vers sa seconde face principale :
- la première électrode,
- la couche électriquement isolante,
- la seconde électrode,
- une première couche en matériau d'un premier type de conductivité,
- une première couche active,
- une couche en matériau d'un deuxième type de conductivité, opposé au premier type de conductivité,
- une deuxième couche en matériau d'un premier type de conductivité, et
- une deuxième couche active.

### BRÈVE DESCRIPTION DES DESSINS

D'autres caractéristiques et avantages de l'invention ressortiront mieux de la description qui va suivre et des dessins annexés dans lesquels :
- la figure 1 représente une vue partielle, en coupe et de profil, d'une cellule photovoltaïque selon un premier mode de réalisation de l'invention,
- la figure 2 représente une vue partielle, en coupe et de profil, d'une cellule photovoltaïque selon un deuxième mode de réalisation de l'invention,
- la figure 3 représente une vue partielle, en coupe et de profil, d'une cellule photovoltaïque selon un troisième mode de réalisation de l'invention,
- la figure 4 représente une vue partielle, en coupe et de profil, d'une cellule photovoltaïque selon un quatrième mode de réalisation de l'invention,
- la figure 5 représente une vue partielle, en coupe et de profil, d'une cellule photovoltaïque selon un cinquième mode de réalisation de l'invention,
- la figure 6 représente une vue partielle, en coupe et de profil, d'une cellule photovoltaïque selon un sixième mode de réalisation de l'invention.
- la figure 7 représente une vue partielle, en coupe et de profil, d'une cellule photovoltaïque selon un septième mode de réalisation de l'invention.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

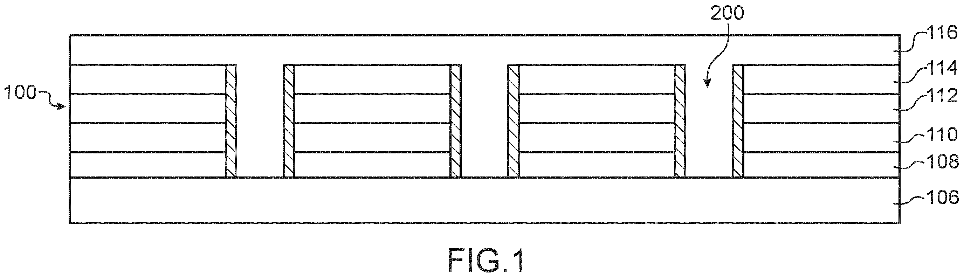

On se réfère aux figures 1 à 7 qui représentent une vue partielle, en coupe et de profil d'une cellule photovoltaïque selon divers modes de réalisation particuliers de l'invention.

La cellule photovoltaïque comprend un substrat 100 comportant une première face principale 102 et une seconde face principale 104 parallèles l'une par rapport à l'autre. Par parallèle, on entend parallèle ou sensiblement parallèle.

L'une des faces, ici la première face principale 102 correspond à la face arrière. La seconde face principale 104, est destinée à recevoir les rayons lumineux, il s'agit de la face avant.

Les faces avant 104 et arrière 102 ne sont pas texturées sur les figures. Cependant, pour mieux piéger la lumière, la face avant 104 pourrait être texturée. La face arrière 102 pourrait également présenter une texturation semblable ou différente de celle de la face avant.

Le substrat 100 comprend depuis la première face principale 102 vers la seconde face principale 104 un empilement comprenant, et de préférence, constitué par :
- une première électrode 106,
- une couche électriquement isolante 108,
- une seconde électrode 110,
- une couche en matériau d'un premier type de conductivité 112, et
- une couche active 114.

La première électrode 106 est aussi appelée électrode inférieure et la seconde électrode 110 est aussi appelée électrode supérieure. La première électrode 106 peut être disposée sur un ou plusieurs éléments qui forment un support.

La première électrode 106 et la seconde électrode 110, chargées de collecter le courant généré, sont séparées et isolées électriquement l'une de l'autre par une couche électriquement isolante 108. La couche électriquement isolante 108 peut être en polyéthène téréphtalate (PET) ou en polyéthylène (PE).

Dans une variante non représentée, la première électrode 106 et la seconde électrode 110 pourraient être interdigitées verticalement, chacune étant positionnée dans un plan du substrat.

Comme les électrodes 106, 110, dans ce type d'architecture, sont positionnées en face arrière 102, les électrodes 106, 110 peuvent, avantageusement, être opaques ou de transparence limitée, par exemple, en métal. Elles sont, par exemple, en argent, en or, en chrome ou en aluminium.

La seconde électrode 110 est électriquement connectée à la couche en matériau d'un premier type de conductivité 112. La première électrode 106 est électriquement isolée de la couche d'un premier type de conductivité 112. La couche 112 en matériau d'un premier type de conductivité, de type N ou de type P, est aussi appelée première couche d'interface.

Une couche de type P est, par exemple, du Poly(3,4-ethylenedioxythiophene) Polystyrene sulfonate (PEDOT:PSS) ou un oxyde métallique tel qu'un oxyde de molybdène, un oxyde de vanadium ou un oxyde de tungstène.

Une couche de type N est, par exemple, un oxyde métallique tel que l'oxyde de zinc (ZnO), de l'oxyde de zinc dopé à l'aluminium aussi appelé AZO (ZnO:Al), l'oxyde de titane (TiO₂) ou l'oxyde d'étain (SnO₂).

La couche active 114 absorbe les photons et génère les charges libres.

Dans un mode de réalisation particulier, la cellule photovoltaïque est une cellule organique : la couche active 114 est une couche organique. Il peut s'agir, par exemple, d'une hétérojonction entre un polymère donneur et une molécule acceptrice. Pour les polymères donneurs, on peut citer par exemple le poly(3-hexyl)thiophène : (P3HT), le poly[2-méthoxy-5-(3,7-diméthyloctyloxy)-1,4-phénylène-vinylène] (MDMO-PPV), ou le poly[N-9'-heptadecanyl-2,7-carbazole-alt-5,5-(4,7-di-2-thienyl-2',1',3'-benzothiadiazole] (PCDTBT). Un exemple de molécule acceptrice est le [6,6]-phényl-C₆₁-butyrate de méthyle.

Dans un autre mode de réalisation, la cellule photovoltaïque est une cellule pérovskite, auquel cas la couche active 114 contient au moins un matériau pérovskite.

Ce matériau pérovskite peut notamment répondre à la formule générale ABX₃ avec:
A représentant un ou plusieurs cations choisis parmi les cations organiques, tels que le cation méthylammonium (CH₃NH₃⁺ ou MA⁺) ou le cation formamidinium ([CH(NH₂)₂⁺ ou FA⁺), et métalliques, comme le cation césium Cs⁺ ou le cation rubidium Rb⁺ ;
B représentant un cation métallique comme Pb²⁺, Sn²⁺, Ag²⁺, Co²⁺, ou un de leurs mélanges ; et
X représentant un ou plusieurs anions halogénures, typiquement Cl⁻, Br⁻ ou I⁻.

Plus particulièrement, le matériau pérovskite peut avoir pour formule APbX₃ avec A et X tels que précédemment définis. Ainsi, il peut notamment s'agir d'un matériau de formule FAPbX₃ ou MAPbX₃ tel que l'iodure de plomb méthylammonium CH₃NH₃Pbl₃, ou bien d'un matériau de formule [Cs₁₋ₓFAₓ]Pb[I_{1-y}Br_{y}]₃ tel que Cs_{0,5}FA_{0,95}Pbl_{2,87}Br_{0,13}.

En variante, le matériau pérovskite peut également répondre à la formule générale A₃Bi₂X₉ avec A représentant un cation MA⁺ ou Cs⁺ et X représentant un anion halogénure choisi parmi Cl⁻, Br⁻ et I⁻. Ainsi, il peut par exemple s'agir du matériau de formule MA₃Bi₂I₉.

En variante encore, le matériau pérovskite peut répondre à la formule AgBi₂I₇.

Comme représenté sur les figures 1 à 5, le substrat 100 est recouvert par une couche 116 en matériau d'un second type de conductivité, opposé au premier type de conductivité. Cette couche 116 est également appelée seconde couche d'interface. Elle forme l'émetteur de la cellule photovoltaïque. Par exemple, si la couche 112 en matériau est de type P, la couche 116 est de type N, et vice-versa.

Comme représenté sur la figure 1, le substrat 100 comprend, en outre, une pluralité de trous borgnes 200. Les trous borgnes 200 sont aussi appelés vias. Les trous borgnes sont formés d'une ouverture 202, d'un fond 204 et d'une paroi latérale 206. L'ouverture 202 est disposée au niveau de la seconde face 104. La première électrode 106 définit le fond 204 des trous borgnes 200. Ainsi, les trous borgnes 200 sont disposés de manière à mettre à jour la première électrode 106. Il est alors possible de réaliser une prise de contact sur la première électrode 106 depuis la seconde face 104 du substrat 100. La couche 116 en matériau d'un second type de conductivité remplit au moins partiellement les trous borgnes 200 de manière à prendre contact avec la première électrode 106. L'émetteur 116 de la cellule est ainsi formé d'une couche mince recouvrant la seconde face principale 104 du substrat 100 et de portions longitudinales de matériau disposées dans les trous borgnes 200 du substrat 100.

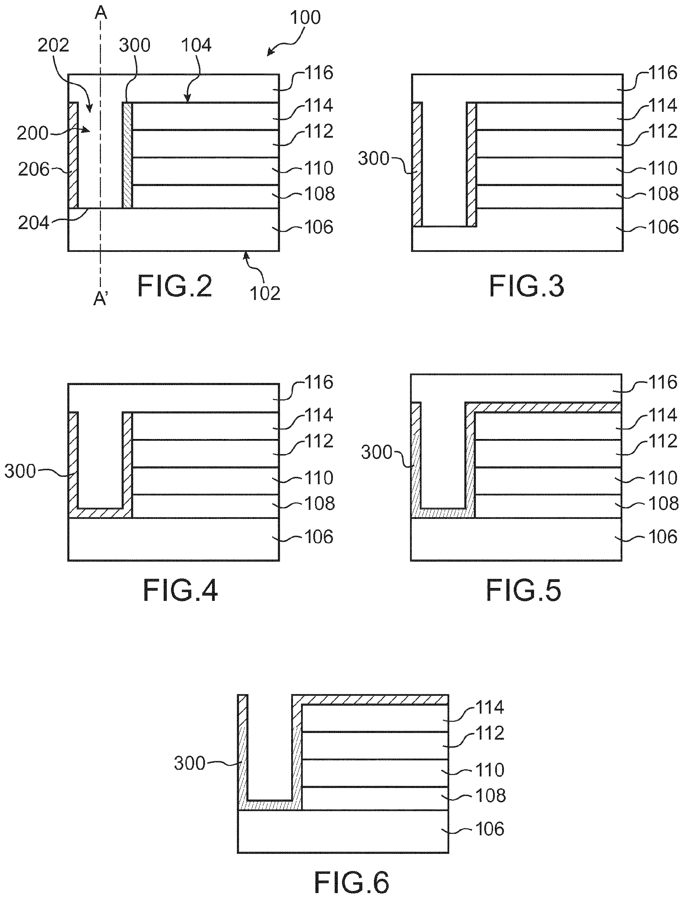

Les figures 2 à 7 représentent un seul trou borgne pour plus de lisibilité.

Comme représenté sur la figure 2, la paroi latérale 206 s'étend parallèlement à l'axe du trou AA'.

Selon une variante représentée sur la figure 3, le fond 204 du trou 200 ne coïncide pas exactement avec la surface de la première électrode 106. Une partie de la paroi latérale 206 du trou est alors formée du matériau de la première électrode 106.

Chaque trou borgne 200 a un diamètre allant de 10 µm à 500 µm, et de préférence allant de 20 µm à 100 µm. Avantageusement, les trous 200 sont régulièrement espacés les uns des autres. La taille et la répartition des trous borgnes 200 seront choisies selon un compromis entre la conductivité des couches, la proportion de surface du dispositif occupée par la surface active, et éventuellement l'aspect esthétique du dispositif (homogénéité de coloration).

La section des trous 200 dans un plan parallèle aux faces principales 102, 104 du substrat 100 est, préférentiellement, circulaire. Selon d'autres modes de réalisation, elle pourrait être triangulaire, en carré, en étoile ou toute autre forme polygonale régulière ou non. La surface de la section des trous au niveau de la première face principale peut être identique ou différente de celle de la surface de la section des trous au niveau de la seconde face principale.

La cellule photovoltaïque comporte, en outre, une couche d'isolation électriquement isolante 300 protégeant au moins partiellement l'empilement du substrat 100 de la vapeur d'eau et de l'oxygène.

La couche d'isolation tapisse la paroi latérale 206 du trou borgne 200. Par « tapisse la paroi latérale 206 du trou borgne 200 », on entend que la couche d'isolation 300 recouvre et est en contact avec la paroi latérale 206 du trou borgne 200. Elle ne présente pas de discontinuité au niveau de la paroi 206. Autrement dit, la couche d'isolation 300 est en contact avec les différentes couches de l'empilement du substrat 100, hormis la première électrode 106 qui forme le fond du trou 204.

La couche d'isolation électriquement isolante 300 présente une mobilité inférieure à 1cm²/V.s. Ce type de revêtement permet de limiter les fuites de courant en isolant la couche 116 des couches 112 et 110.

Elle a, de préférence, une épaisseur conforme.

La couche d'isolation 300 est, par exemple, en alumine et elle a une épaisseur supérieure ou égale à 5 nm, de préférence allant de 5 nm à 100 nm. Elle permet d'éviter les contacts électriques entre l'émetteur 116 et la première couche d'interface 112 et l'électrode 110. Les performances de la cellule photovoltaïque sont ainsi améliorées. La couche d'isolation 300 tapisse uniquement la paroi latérale 206 du trou borgne 200. Elle ne recouvre pas le fond 204 du trou pour permettre un contact électrique entre l'émetteur 116 et la première électrode 106 (figures 1 à 3).

Selon un autre mode de réalisation, représenté aux figures 4 et 5, la couche d'isolation 300 est en alumine et elle a une épaisseur inférieure à 5 nm, de préférence comprise entre 1 nm et 2 nm, afin de permettre le transport des charges, par effet tunnel, à travers son épaisseur. Dans ce mode de réalisation, la couche d'isolation 300 peut recouvrir le fond 204 des trous 200 (figure 4).

Comme représenté sur la figure 5, la couche d'isolation 300 peut recouvrir le fond 204 des trous 200 et la couche active 114.

Selon un mode de réalisation particulier, représenté à la figure 6, la couche d'isolation 300 présente un gradient de conductivité dans un plan perpendiculaire à son épaisseur, de manière à être, à la fois, électriquement isolante et en un matériau d'un second type de conductivité, opposé au premier type de conductivité. Elle recouvre la couche active 114. En plus de son rôle d'isolation, la couche 300 remplit le rôle de couche d'interface, de type N ou de type P, ce qui réduit le temps de fabrication des cellules et leur coût. La partie électriquement isolante a, par exemple, une épaisseur inférieure à 5 nm pour permettre le transport des charges par effet tunnel.

La couche d'isolation 300 peut, également, être sous la forme d'un bicouche matériau électriquement isolant/matériau d'un second type de conductivité. Elle peut également être sous la forme d'un tricouche matériau électriquement isolant/matériau d'un second type de conductivité/matériau ayant des propriétés barrière.

Dans ce mode de réalisation, la couche d'isolation 300 recouvre le fond 204 du trou 200 et est en contact avec la première électrode 106.

La couche d'isolation 300 aura, dans ce mode de réalisation, avantageusement, les propriétés suivantes : conductivité électrique pour transporter les charges, transparence pour laisser passer le rayonnement solaire. Eventuellement, la couche d'isolation 300 peut filtrer les UV. Le niveau d'énergie sera choisi en de la conductivité recherchée (type N ou type P).

Préférentiellement, dans le cas d'une couche de type P, la couche d'isolation 300 est de l'oxyde de tungstène WO₃.

Préférentiellement, dans le cas d'une couche de type N, la couche d'isolation 300 est une couche de TiO₂ ou une couche de ZnO.

Les oxydes peuvent être dopés. Une couche d'oxyde de zinc dopé à l'aluminium ZnO:Al (AZO) peut être utilisée pour former une couche de type N.

Une couche d'isolation 300 avec un gradient de densité et/ou un gradient de dopant sera, avantageusement, choisie de manière à répondre à plusieurs des critères recherchés. Le gradient se situe dans un plan perpendiculaire à l'épaisseur de la couche d'isolation. Par exemple, au début de dépôt, la couche d'isolation 300 présente des propriétés d'isolation puis elle présentera une meilleure conductivité électrique pour transporter les charges, et finalement en fin de dépôt la couche sera plus dense, répondant aux critères de couches barrières. Le matériau formant la couche d'isolation 300 est différent des matériaux formant les couches de l'empilement du substrat 100.

Conformément à l'invention, la cellule photovoltaïque peut-être une cellule tandem, c'est-à-dire comprendre deux couches actives, par exemple, chacune de type pérovskite.

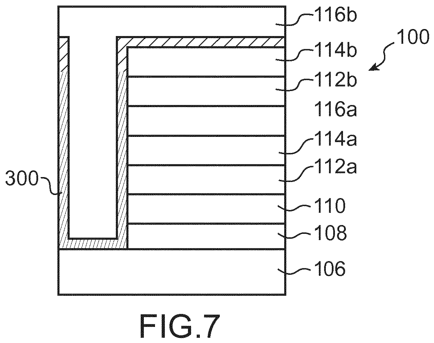

Un exemple de réalisation d'une cellule photovoltaïque tandem est illustré sur la figure 7 dans lequel cette cellule comprend :
(1) un substrat 100 comprenant :
   - la première électrode 106 ;
   - la couche électriquement isolante 108 ;
   - une première couche en matériau d'un premier type de conductivité 112a ;
   - une première couche active 114a ;
   - une première couche en matériau d'un second type de conductivité 116a, opposé au premier type de conductivité ;
   - une deuxième couche en matériau d'un premier type de conductivité 112b ; et
   - une deuxième couche active 114b ;
(2) la couche d'isolation 300 électriquement isolante qui, dans le cas du mode de réalisation représenté sur la figure 7, non seulement tapisse la paroi latérale 206 des trous borgnes 200 mais recouvre aussi la deuxième couche active 114b ainsi que le fond 204 des trous borgnes 200 ; et
(3) une deuxième couche en matériau d'un deuxième type de conductivité 116b qui recouvre la couche d'isolation 300 et se prolonge dans les trous borgnes 200.

Ainsi, si les couches 112a et 112b sont en matériau de type N, alors les couches 116a et 116b sont en matériau de type P. À l'inverse, si les couches 112a et 112b sont en matériau de type P, alors les couches 116a et 116b sont en matériau de type N.

L'invention concerne, en outre, un procédé de réalisation d'une cellule photovoltaïque organique ou pérovskite comportant au moins les étapes de :
a) réaliser un substrat 100 comportant une première face principale 102 et une seconde face principale 104 parallèles l'une par rapport à l'autre,
   le substrat 100 comprenant depuis la première face principale 102 vers la seconde face principale 104 un empilement comprenant, et de préférence constitué par :
   - une première électrode 106,
   - une couche électriquement isolante 108,
   - une seconde électrode 110,
   - une couche en matériau d'un premier type de conductivité 112, et
   - une couche active 114,
b) réaliser une pluralité de trous borgnes 200 dans le substrat, chaque trou borgne 200 étant formé d'une ouverture 202, d'un fond 204 et d'une paroi latérale 206, l'ouverture 202 étant disposée au niveau de la seconde face 104, la première électrode 106 définissant le fond du trou borgne 200,
c) déposer une couche d'isolation 300, de préférence conforme, sur la paroi latérale 206 et sur le fond 204 du trou borgne 200 par dépôt de couche atomique.

L'étape a) peut être réalisée par dépôts successifs des différentes couches à température ambiante ou modérée. Par température ambiante, on entend une température de 20-25°C, et par température modérée, on entend une température supérieure à 25°C et pouvant aller jusqu'à 70°C. L'empilement peut être soumis à une étape de recuit. Par exemple, pour former la couche active 114 d'une cellule solaire organique, une solution de P3HT:PCBM peut être déposée par dépôt à la tournette. Un recuit à une température de 100-150°C pendant quelques minutes peut être réalisé pour sécher la couche active.

Lors de l'étape b), les trous 200 sont, préférentiellement, réalisés par ablation laser ou gravure mécanique. Selon des variantes, ils pourraient être réalisés par gravure chimique ou plasma.

Lors de l'étape c), la couche d'isolation 300 est, de préférence, déposée par dépôt de couche atomique (ALD pour « Atomic Layer Deposition »), pour obtenir un dépôt conforme sur les parois 206 des vias 200. La couche d'isolation peut également être déposée par dépôt de couche atomique assisté par plasma (ou PE-ALD pour « plasma enhanced ALD »).

Selon une autre alternative, la couche d'isolation 300 peut être déposée par dépôt chimique en phase vapeur assisté par plasma (ou PECVD pour « Plasma-Enhanced Chemical Vapor Déposition » en anglais).

On peut également obtenir des couches conformes par le procédé i-CVD ou FA-CVD (« initiated CVD » ou « Filament Assisted CVD »).

Le procédé peut comprendre une étape d), successivement à l'étape c) dans laquelle une couche en matériau d'un second type de conductivité 116, opposé au premier type de conductivité, est déposée sur le substrat, la couche en matériau d'un second type de conductivité remplissant au moins partiellement les trous borgnes 200 de manière à prendre contact avec la seconde électrode 106.

Entre l'étape c) et l'étape d), le procédé peut comprendre une étape additionnelle dans laquelle la partie de la couche d'isolation 300 recouvrant le fond 204 des trous 200 est gravée, de manière à rendre accessible la première électrode 106. Elle est, par exemple, gravée avec un laser, ou encore par gravure chimique.

Dans un mode de réalisation, la couche d'isolation 300 est déposée sur le fond 204 et les parois 206 des trous 200 ainsi que sur la couche active 114. La partie de la couche d'isolation 300 recouvrant la couche active 114 peut être retirée par gravure ou polissage.

Le procédé comporte une étape ultérieure dans laquelle la cellule photovoltaïque est encapsulée, par exemple par laminage de films barrières aux gaz maintenus sur la cellule photovoltaïque au moyen d'un film d'EVA. Le film barrière peut être placé de part et d'autre des deux faces de la cellule ou uniquement sur la face avant 104, la face arrière 102 étant constituée d'un métal d'un seul tenant (pas de trous donc pas de perméation). Les techniques d'encapsulation étant bien connues de l'homme du métier, elles ne seront pas détaillées ici.

De manière illustrative et non limitative, une cellule photovoltaïque de type NIP peut être réalisée selon les étapes suivantes :
- formation d'un empilement comprenant deux électrodes métalliques 106, 110 séparées par une couche électriquement isolante 108, par exemple, il peut s'agir d'argent et de chrome d'épaisseur 200 nm sur du PET d'épaisseur 150 µm,
- formation d'une couche de type N 112, par exemple du ZnO d'épaisseur 50 nm, sur l'électrode supérieure 110, éventuellement suivi d'un recuit,
- formation d'une couche active 114 (par exemple P3HT:PCBM d'épaisseur 200 nm ou perovskite CH₃NH₃Pbl3 de 300 nm) sur la couche de type N 112,
- gravure laser à travers la couche active 114, la couche de type N 112, l'électrode supérieure 110 et la couche électriquement isolante 108 de manière à former des vias 200 et rendre accessible l'électrode inférieure 106,
- dépôt d'une couche d'alumine 300 de 5nm par ALD,
- formation de la couche de type P 116, par exemple par dépôt en voie liquide d'une solution de PEDOT:PSS, ou par dépôt par ALD d'une couche de WO₃ dopé ou non dopé, puis recuit
- encapsulation, par exemple par lamination d'un film barrière aux gaz et d'un encapsulant en face avant.

De manière illustrative et non limitative, une cellule photovoltaïque de type PIN peut être réalisée selon les étapes suivantes :
- formation d'un empilement comprenant deux électrodes métalliques 106, 110 séparées par une couche électriquement isolante 108, par exemple argent et chrome d'épaisseur 200 nm sur du PET d'épaisseur 150 µm
- formation d'une couche de type P 112 (par exemple 100 nm de PEDOT-PSS) sur l'électrode supérieure 110, éventuellement suivi d'un recuit,
- formation d'une couche active 114 (par exemple P3HT:PCBM d'épaisseur 200 nm ou perovskite CH₃NH₃Pbl₃ de 300 nm) sur la couche de type P 112,
- gravure laser à travers la couche active 114, la couche de type P 112, l'électrode supérieure 110 et la couche électriquement isolante 108 de manière à former des vias 200 et rendre accessible l'électrode inférieure 106,
- dépôts successifs par ALD d'une couche de 20 nm de ZnO:Al puis d'une couche de 20 nm de ZnO dense pour former une couche de séparation 300 ayant les propriétés d'une couche de type N.

## Revendications

1. Cellule photovoltaïque organique ou pérovskite comprenant un substrat (100) muni d'une première face principale (102) et d'une seconde face principale (104) parallèles l'une par rapport à l'autre,
le substrat (100) comprenant depuis la première face principale (102) vers la seconde face principale (104) un empilement formé de :
- une première électrode (106),
- une couche électriquement isolante (108),
- une seconde électrode (110),
- une couche en matériau d'un premier type de conductivité (112), et
- une couche active (114),
le substrat (100) comprenant une pluralité de trous borgnes (200), chaque trou borgne (200) étant formé d'une ouverture (202), d'un fond (204) et d'une paroi latérale (206), l'ouverture (202) étant disposée au niveau de la seconde face (104), la première électrode (106) définissant le fond des trous borgnes (200),
**caractérisée en ce que** la cellule photovoltaïque comporte, en outre, une couche d'isolation (300) électriquement isolante tapissant la paroi latérale des trous borgnes (200).

2. Cellule photovoltaïque selon la revendication 1, **caractérisée en ce que** la couche d'isolation (300) a une épaisseur conforme.

3. Cellule photovoltaïque selon l'une des revendications 1 et 2, **caractérisée en ce que** la couche d'isolation (300) est en alumine ou en silice et **en ce qu'**elle a une épaisseur supérieure ou égale à 5 nm, de préférence allant de 5 nm à 25 nm.

4. Cellule photovoltaïque selon l'une des revendications 1 et 2, **caractérisée en ce que** la couche d'isolation (300) est en alumine ou en silice et **en ce qu'**elle a une épaisseur strictement inférieure à 5nm, de préférence comprise entre 1nm et 5nm.

5. Cellule photovoltaïque selon la revendication précédente, **caractérisée en ce que** la couche d'isolation (300) recouvre le fond (204) des trous (200).

6. Cellule photovoltaïque selon l'une quelconque des revendications précédentes, **caractérisée en ce que** le substrat (100) est recouvert par une couche en matériau d'un second type de conductivité (116), opposé au premier type de conductivité, la couche en matériau d'un second type de conductivité (116) remplissant au moins partiellement les trous borgnes (200) de manière à prendre contact avec la première électrode (106).

7. Cellule photovoltaïque selon l'une des revendications 1 et 2, **caractérisée en ce que** la couche d'isolation (300) est en contact avec la première électrode (106) et **en ce qu'**elle présente un gradient de conductivité électrique, dans un plan perpendiculaire à l'épaisseur de la couche d'isolation (300), la surface interne de la couche d'isolation en contact avec la paroi latérale (206) du trou borgne (200) étant en un matériau électriquement isolant et la surface externe, opposée à la surface interne, étant en un matériau d'un second type de conductivité, opposé au premier type de conductivité.

8. Cellule photovoltaïque selon la revendication 7, **caractérisée en ce que** le matériau d'un second type de conductivité est du TiO₂, du WO₃ dopé ou non dopé, du ZnO ou du ZnO:AI.

9. Cellule photovoltaïque selon l'une quelconque des revendications précédentes, **caractérisée en ce que** la couche d'isolation (300) présente un gradient de densité et/ou un gradient de dopant, dans un plan perpendiculaire à l'épaisseur de la couche d'isolation (300).

10. Cellule photovoltaïque selon l'une quelconque des revendications précédentes, **caractérisée en ce que** la couche d'isolation (300) recouvre la couche active (114).

11. Procédé de réalisation d'une cellule photovoltaïque organique ou pérovskite, comportant au moins les étapes de :
a) réalisation d'un substrat (100) comportant une première face principale (102) et une seconde face principale (104) parallèles l'une par rapport à l'autre, le substrat (100) comprenant depuis la première face principale (102) vers la seconde face principale (104) un empilement comprenant :
- une première électrode (106),
- une couche électriquement isolante (108),
- une seconde électrode (110),
- une couche en matériau d'un premier type de conductivité (112), et
- une couche active (114),
b) réalisation d'une pluralité de trous borgnes (200), chaque trou borgne (200) étant formé d'une ouverture (202), d'un fond (204) et d'une paroi latérale (206), l'ouverture (202) étant disposée au niveau de la seconde face (104), la première électrode (106) définissant le fond des trous borgne (200),
c) dépôt d'une couche d'isolation (300) électriquement isolante sur la paroi latérale (206) et sur le fond (204) des trous borgnes (200).

12. Procédé selon la revendication 11, **caractérisé en ce que** la couche d'isolation (300) électriquement isolante est formée par dépôt de couche atomique.

13. Procédé selon l'une des revendications 11 et 12, **caractérisé en ce que** le procédé comprend une étape d) dans laquelle une couche en matériau d'un second type de conductivité (116), opposé au premier type de conductivité, est déposée sur le substrat (100), la couche en matériau d'un second type de conductivité (116) remplissant au moins partiellement les trous borgnes (200) de manière à prendre contact avec la seconde électrode (106).

14. Procédé selon la revendication 13, **caractérisé en ce que**, entre l'étape c) et l'étape d), le procédé comprend une étape additionnelle dans laquelle la partie de la couche d'isolation (300) recouvrant le fond (204) des trous est gravée, de manière à rendre accessible la première électrode (106).

15. Procédé selon l'une des revendications 11 et 12, **caractérisé en ce que** la couche d'isolation (300) présente un gradient de conductivité électrique, dans un plan perpendiculaire à l'épaisseur de la couche d'isolation (300), la surface interne de la couche d'isolation (300) en contact avec la paroi latérale (206) du trou borgne (200) étant en un matériau électriquement isolant et la surface externe, opposée à la surface interne, étant en un matériau d'un second type de conductivité, opposé au premier type de conductivité.

16. Procédé selon l'une quelconque des revendications 11 à 15, **caractérisé en ce qu'**il comporte une étape ultérieure dans laquelle la cellule photovoltaïque est encapsulée.
